# EUROPEAN PATENT APPLICATION

(11) **EP 0 854 512 A2**
(43) Date of publication of application: **22.07.1998**
(21) Application number: 98100852.7
(22) Date of filing: 19.01.1998
(51) Int. Cl.: H01L 23/48, H01L 23/66

(54) **Integrated device for the microwave band**

(30) Priority: 21.01.1997 JP 8823/97
(71) Applicant: MURATA MANUFACTURING CO., LTD., Nagaokakyo-shi Kyoto-fu (JP)
(72) Inventor: Ishikawa, Yohei, Nagaokakyo-shi, Kyoto-fu (JP); Sakamoto, Koichi, Nagaokakyo-shi, Kyoto-fu (JP); Tanaka, Hiroaki, Nagaokakyo-shi, Kyoto-fu (JP)
(74) Representative: Schoppe, Fritz, Dipl.-Ing.

(57) **Abstract**

An integrated device (1) includes a first ground electrode (3) formed on the bottom surface of a GaAs substrate (2), second ground electrodes (6) formed between a plurality of elements (4), and a third ground electrode (8) formed on a dielectric layer (7) which is formed on the GaAs substrate (2). They are connected to via holes (9) formed such that the distance (d) therebetween is set smaller than half the wavelength of the used signal.

## Description

### BACKGROUND OF THE INVENTION

### 1. Field of the Invention

The present invention relates to integrated devices, and more particularly, to an integrated device used in the microwave band and the millimeter-wave band.

### 2. Description of the Related Art

In a conventional integrated device, such as a monolithic micro-wave IC (MMIC) in which a plurality of elements are provided on a GaAs substrate and are wired to each other, sufficient isolation is not obtained between the elements. In other words, a signal may be transmitted from an element to another element through a path other than the primary signal line, or a signal may be transmitted to an element to which the signal is not intended to reach. This unnecessary signal transmission is caused mainly through the inside of the GaAs substrate and the space over the surface of the GaAs substrate on which the elements are formed. The following countermeasure is disclosed in the Japanese Unexamined Patent Publication No. 3-165058.

Fig. 3 illustrates an integrated device shown in the Japanese Unexamined Patent Publication No. 3-165058. In Fig. 3, an integrated device 10 includes a GaAs substrate 11, a ground electrode 12 formed on the bottom surface of the GaAs substrate 11, elements 13 and 14 formed on the upper surface of the GaAs substrate 11, connection wiring 15 which connects the elements 13 and 14, ground electrodes 16 formed on the upper surface of the GaAs substrate 11, a dielectric layer 17 formed on the GaAs substrate 11, ground electrodes 18 formed on the upper section of the dielectric layer 17, and a plurality of via holes 19 which connect the ground electrodes 16, the ground electrode 12, and the ground electrodes 18. The distance between the via holes 19 is set smaller than the wavelength of the used signal.

An array-shaped electromagnetic shield is formed of the via holes 19 at portions other than a section where the connection wiring 15 is formed between the two elements 13 and 14.

In the integrated device 10 formed in this way, a signal output from the element 13 is input to the element 14 through the connection wiring 15. As the signal is output, the element 13 emits a signal in space to the insides of the GaAs substrate 11 and the dielectric layer 17 mainly in the form of electromagnetic waves. In the same way, the element 14 emits a signal. Transmission of these signals to surrounding other elements (for example, from the element 13 to the element 14, or from the element 14 to the element 13) may adversely affect signal processing in the integrated device 10.

With the electromagnetic shield formed of the ground electrodes 12, 16, and 18 and the via holes 19 disposed between the two elements 13 and 14, unnecessary signal transmission between the two elements 13 and 14 is blocked to some extent in the integrated device 10 and isolation between the two elements 13 and 14 is improved.

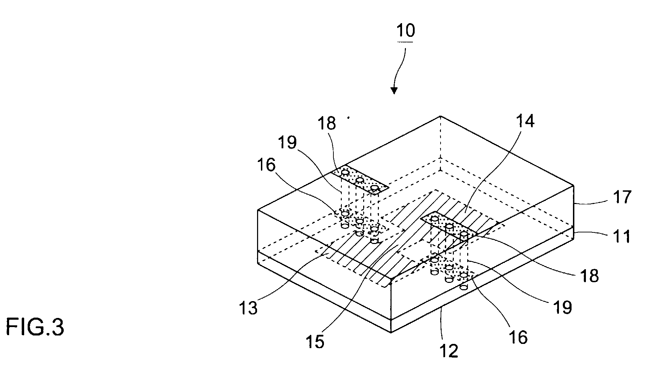

In the conventional case in Fig. 3, the via holes 19 are formed only between the elements 13 and 14. When the via holes 19 are formed such that they surround each of the elements 13 and 14, isolation is further increased.

In the conventional case in Fig. 3, however, signal transmission through the space over the elements is not sufficiently blocked, and it is difficult to achieve complete isolation. Therefore, the distance between the elements needs to be large, and as a result, it is difficult to make the integrated device compact.

### SUMMARY OF THE INVENTION

Accordingly, it is an object of the present invention to provide an integrated device which can be made compact and in which complete isolation is achieved between elements.

The foregoing object is achieved according to the present invention through the provision of an integrated device including:
a GaAs substrate;
a first ground electrode formed in a plane manner on the bottom surface of the GaAs substrate;
a plurality of elements formed on the upper surface of the GaAs substrate;
second ground electrodes formed around each of the plurality of elements at portions excluding connection wiring which connects the plurality of elements, on the upper surface of the GaAs substrate;
a dielectric layer formed on the GaAs substrate so as to cover the plurality of elements and the connection wiring;
a third ground electrode formed in a plane manner at the upper section of the dielectric layer; and
a plurality of via holes for connecting the second ground electrodes to the first and third ground electrodes.

In the integrated device, the dielectric constant of the dielectric layer may be smaller than that of the GaAs substrate. In the integrated device, the distance between adjacent via holes among the plurality of via holes may be smaller than half the wavelength of the used signal, which is determined by the dielectric constants of the GaAs substrate and the dielectric layer.

With this configuration, complete isolation can be obtained between the elements on the GaAs substrate in an integrated device according to the present invention.

According to an integrated device of the present invention, since the elements formed on the GaAs substrate is surrounded by the waveguide-shaped shield formed of the upper and lower ground electrodes and the via holes formed in an array around the elements, except for the connection wiring for the elements, unnecessary transmission of signals between the elements is completely eliminated and isolation between the elements is improved.

Due to improved isolation between the elements, the distance between the elements can be made short, and thereby the integration level is increased and the integrated device is made compact.

### BRIEF DESCRIPTION OF THE DRAWINGS

Fig. 1 is a top view of an integrated device according to an embodiment of the present invention.

Fig. 2 is a cross section of the embodiment shown in Fig. 1 taken on line A-A.

Fig. 3 is a perspective view of a conventional integrated device.

### DESCRIPTION OF THE PREFERRED EMBODIMENT

An embodiment of the present invention will be described below by referring to the drawings.

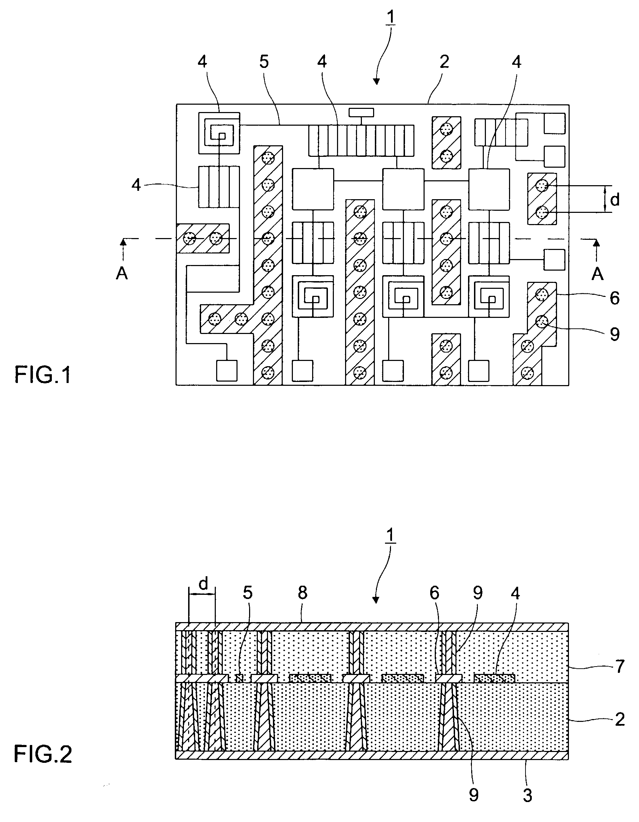

Figs. 1 and 2 show an integrated device according to an embodiment of the present invention. Fig. 1 is a top view and Fig. 2 is a cross section of the integrated device shown in Fig. 1 taken on line A-A when viewed from the side.

In Figs. 1 and 2, an integrated device 1 includes a GaAs substrate 2, a first ground electrode 3 formed on the entire surface of the bottom surface of the GaAs substrate 2, a plurality of elements 4 formed on the upper surface of the GaAs substrate 2, connection wiring 5 which connects the plurality of elements 4, second ground electrodes 6 formed at portions excluding the connection wiring 5 around the elements 4 on the upper surface of the GaAs substrate 2, a dielectric layer 7 formed on the GaAs substrate 2 so as to cover the elements 4 and the connection wiring 5, a third ground electrode 8 formed on the entire surface of the upper surface of the dielectric layer 7, and a plurality of via holes 9 which connect the second ground electrodes 6 to the first and third ground electrodes 3 and 8. The via holes 9 are formed so as to surround the elements 4 at portions excluding the connection wiring 5. The distance "d" between the via holes 9 is set smaller than half the wavelength of the used signal flowing through the elements 4 and the connection wiring 5, which is determined by the dielectric constants of the GaAs substrate 2 and the dielectric layer 7. The dielectric constant of the dielectric layer 7 is set smaller than that of the GaAs substrate 2.

Since the via holes 9 are formed such that the distance "d" therebetween is set smaller than half the wavelength of the used signal, they serve as an electromagnetic shield for the used signal. As a result, except for portions where the connection wiring 5 is formed between the plurality of elements 4, the array-shaped electromagnetic shield is formed of the via holes 9 at sides and shields are formed of the first and third ground electrodes 3 and 8 at the upper and lower surfaces. Consequently, the elements 4 are trapped in a waveguide formed of the first, second, and third ground electrodes 3, 6, and 8 and the via holes 9.

In the integrated device 1 formed in this way, a signal output from an element 4 is input to another element 4 through the connection wiring 5. As the signal is output and input, the elements 4 emit signals to the insides of the GaAs substrate 2 and the dielectric layer 7 mainly in the form of electromagnetic waves. Transmission of these signals to other surrounding elements 4 may adversely affect signal processing in a form of signal mixture.

With the waveguide-shaped shield formed of the first, second, and third ground electrodes 3, 6, and 8 and the via holes 9 disposed between the plurality of elements 4, unnecessary signal transmission between the elements 4 is blocked in the integrated device 1 for the used signal and isolation between the elements 4 is improved.

Since isolation between the plurality of elements 4 is improved in the integrated device 1 of the present invention, the distance between the elements 4 can be made short, and thereby the integration level of the elements 4 is increased and the integrated device is made compact.

In the integrated device 1 of the present invention, the dielectric constant of the dielectric layer 7 is set smaller than that of the GaAs substrate 2. Therefore, the distribution of the electromagnetic field generated from the elements 4 is stronger in the inside of the GaAs substrate 2 than in the inside of the dielectric layer 7.

Due to the electromagnetic field distributed in the dielectric layer 7, a current flowing through the third ground electrode 8 becomes low and thereby the loss caused by the current flowing through the third ground electrode 8 becomes low. Especially when the dielectric layer 7 is thin, since a high current tends to flow through the third ground electrode 8, this advantage is noticeable.

## Claims

1. An integrated device (1) comprising:
a substrate (2);
a first ground electrode (3) on the bottom surface of said substrate (2);
a plurality of elements (4) formed on the upper surface of said substrate (2);
second ground electrodes (6) formed around each of said plurality of elements (4) at portions excluding connection wiring (5) which connects said plurality of elements (4), on the upper surface of said substrate (2);
a dielectric layer (7) formed on said substrate (2) so as to cover said plurality of elements (4) and the connection wiring (5);
a third ground electrode (8) formed on the upper section of said dielectric layer (7); and
a plurality of via holes (9) for connecting said second ground electrodes (6) to said first (3) and third (8) ground electrodes.

2. An integrated device (1) according to Claim 1, wherein the dielectric constant of said dielectric layer (7) is smaller than that of said substrate (2).

3. An integrated device (1) according to Claims 1, wherein the distance (d) between adjacent via holes among said plurality of via holes (9) is smaller than half the wavelength of the used signal, which is determined by the dielectric constants of said substrate (2) and said dielectric layer (7).

4. An integrated device (1) according to claim 1, said substrate (2) is made of GaAs.
